# EUROPÄISCHE PATENTSCHRIFT

(11) **EP 2 359 053 B1**
(45) Veröffentlichungstag und Bekanntmachung des Hinweises auf die Patenterteilung: **17.10.2018**
(21) Anmeldenummer: 09801698.3
(22) Anmeldetag: 18.12.2009
(51) Int. Cl.: F21K 9/90, F21Y 115/10, H01L 33/00, H01L 25/075

(54) **VERFAHREN ZUR HERSTELLUNG EINER MEHRZAHL VON LED-BELEUCHTUNGSVORRICHTUNGEN SOWIE EINER MEHRZAHL VON LED-CHIPSÄTZEN FÜR BELEUCHTUNGSVORRICHTUNGEN UND LED-BELEUCHTUNGSVORRICHTUNG**
METHOD FOR FABRICATING A PLURALITY OF LED-BASED ILLUMINATING DEVICES, FOR FABRICATING A PLURALITY OF LED-SETS FOR ILLUMINATING DEVICES, AND LED-BASED ILLUMINATING DEVICE
PROCÉDÉ POUR FABRIQUER UNE PLURALITÉ D'ÉLÉMENTS ÉMETTEURS DE LUMIÈRE À BASE DE DELS, POUR FABRIQUER UNE PLURALITÉ DE BLOCS DE DELS POUR ÉLÉMENTS ÉMETTEURS DE LUMIÈRE, ET ÉLÉMENT ÉMETTEUR DE LUMIÈRE À BASE DE DELS

(30) Priorität: 19.12.2008 DE 102008064073
(43) Veröffentlichungstag der Anmeldung: 24.08.2011
(73) Patentinhaber: OSRAM Opto Semiconductors GmbH, 93055 Regensburg (DE); OSRAM GmbH, 80807 München (DE)
(72) Erfinder: HOFMANN, Markus, 93077 Bad Abbach (DE); BERTRAM, Ralph, Peter, 93152 Nittendorf (DE); MUSCHAWECK, Julius, 82131 Gauting (DE)
(74) Vertreter: Epping - Hermann - Fischer
(86) Internationale Anmeldenummer: PCT/EP2009/067578
(87) Internationale Veröffentlichungsnummer: WO 2010/070120

(56) Entgegenhaltungen:
- US-A1- 2005 030 744
- US-A1- 2005 135 094
- US-A1- 2008 238 335
- US-A1- 2008 308 825

## Beschreibung

Diese Patentanmeldung beansprucht die Priorität der deutschen Patentanmeldung 10 2008 064 073.5

Die vorliegende Erfindung betrifft ein Verfahren zur Herstellung einer Mehrzahl von LED-Beleuchtungsvorrichtungen sowie einer Mehrzahl von Chipsätzen für LED-Beleuchtungsvorrichtungen, die jeweils Licht mit einem Durchschnittswert einer ersten photometrischen Größe emittieren. Weiterhin betrifft die Erfindung eine LED-Beleuchtungsvorrichtung mit mindestens zwei LED-Chips.

Bei LED-Beleuchtungsvorrichtungen mit einer Mehrzahl von LED-Chips werden herkömmlicherweise LED-Chips verwendet, die bei der Herstellung bezüglich ihrer Farbe und Intensität als gleichartig klassifiziert wurden. Dies dient dem Zweck, eine LED-Beleuchtungsvorrichtung mit möglichst gleichen LED-Chips zu bestücken und dadurch einen möglichst homogenen Farbeindruck zu erreichen.

Allerdings zeigen LED-Chips aufgrund ihres Herstellungsprozesses Variationen in nahezu allen Kenngrößen, insbesondere in ihrer Helligkeit und ihrem Farbort. Diese Variationen zeigen sich ebenfalls in LED-Beleuchtungsvorrichtungen, die mit LED-Chips realisiert werden.

Als Folge können daher bei derartigen LED-Beleuchtungsvorrichtungen deutlich sichtbare Unterschiede des Farbeindrucks auftreten. Dieses Problem wird insbesondere bei Weißlicht-LED-Chips beziehungsweise Weißlicht-LED-Beleuchtungsvorrichtungen verschärft, da Abweichungen vom Weißpunkt im Farbraum mit dem menschlichen Auge besonders leicht als Farbstich wahrnehmbar sind.

Insbesondere können sich LED-Beleuchtungsvorrichtungen aufgrund der Variationen der LED-Chips in ihrem Farbort oder ihrer Helligkeit unterscheiden, wodurch sichtbare Differenzen des Farbeindrucks zwischen beispielsweise nebeneinander montierten LED-Beleuchtungsvorrichtungen mit Nachteil auftreten.

US 2005/135094 A1 beschreibt eine weißlicht-emittierende Vorrichtung unter Verwendung von Dioden, die gebrochen weißes Licht emittieren (LEDs).

US 2008/308825 A1 beschreibt eine Leuchtvorrichtung mit einem Einkapselungsmittel.

US 2008/238335 A1 beschreibt eine Lichtquelle mit mehreren weißen LEDs mit verschiedenen Ausgabespektren.
US 2005/030744 A1 beschreibt eine Vorrichtung zum Erzeugen von weißem Licht.

Der Erfindung liegt die Aufgabe zugrunde, ein verbessertes Herstellungsverfahren anzugeben, bei dem Unterschiede der Farborte und/oder der Helligkeit unterschiedlicher LED-Beleuchtungsvorriohtungen zueinander, insbesondere Weißlicht-LED-Beleuchtungsvorrichtungen, mit dem menschlichen Auge nicht wahrnehmbar sind und das gleichzeitig Kostenvorteile bietet. Insbesondere sollen Unterschiede des Farbeindrucks bei derartigen LED-Beleuchtungsvorrichtungen reduziert werden. Weiterhin soll eine Anordnung von LED-Chips, beispielsweise eine LED-Beleuchtungsvorrichtung mit einer möglichst geringen Abweichung von einem vorgegebenen Farbort und/oder einer vorgegebenen Helligkeit, erzeugt werden.

Diese Aufgaben werden unter anderem durch ein Verfahren zur Herstellung einer Mehrzahl von LED-Beleuchtungsvorrichtungen mit den Merkmalen des Patentanspruchs 1 sowie durch ein Verfahren zur Herstellung einer Mehrzahl von LED-Chipsätzen für Beleuchtungsvorrichtungen nach Anspruch 2 gelöst. Ferner werden diese Aufgaben durch eine LED-Beleuchtungsvorrichtung mit den Merkmalen des Anspruchs 10 gelöst. Vorteilhafte Ausführungsformen und bevorzugte Weiterbildungen des Verfahrens und der LED-Beleuchtungsvorrichtung sind Gegenstand der abhängigen Ansprüche.

Erfindungsgemäß weist ein Verfahren zur Herstellung einer Mehrzahl von LED-Beleuchtungsvorrichtungen, die jeweils Licht mit einem Durchschnittswert einer ersten photometrischen Größe emittieren, folgende Verfahrensschritte auf:
- Herstellen einer Mehrzahl von LED-Chips (1), die Licht mit einem gleichen Farbgrundton emittieren,
- Messen der Werte der ersten photometrischen Größe der jeweiligen LED-Chips (1),
- Kombinieren der LED-Chips (1) zu Gruppen von jeweils mindestens zwei LED-Chips (1), die unterschiedliche Werte der ersten photometrischen Größe aufweisen, derart, dass sich die Durchschnittswerte aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden, und
- Bestücken jeweils einer LED-Beleuchtungsvorrichtung (100) mit einer Gruppe von LED-Chips (1), wobei
die LED-Beleuchtungsvorrichtungen mindestens einen weiteren Durchschnittswert einer zweiten photometrischen Größe, der erste LED-Chip einen ersten Wert der zweiten photometrischen Größe und der zweite LED-Chip einen von dem ersten Wert unterschiedlichen zweiten Wert der zweiten photometrischen Größe aufweisen, wobei die LED-Chips derart zu Gruppen kombiniert werden, dass sich die Durchschnittswerte aller LED-Beleuchtungsvorrichtungen um weniger als 10 % voneinander unterscheiden und/oder sich die Durchschnittswerte um weniger als zehn MacAdam-Schwellwerteinheiten voneinander unterscheiden.

Ein Verfahren zur Herstellung von LED-Chipsätzen für Beleuchtungsvorrichtungen, die jeweils Licht mit einem Durchschnittswert einer ersten photometrischen Größe emittieren, weist gemäß einer Ausführungsform folgende Verfahrensschritte auf:
- Herstellen einer Mehrzahl von LED-Chips (1), die Licht mit einem gleichen Farbgrundton emittieren,
- Messen der Werte der ersten photometrischen Größe der jeweiligen LED-Chips (1),
- Kombinieren der LED-Chips (1) zu Gruppen von jeweils mindestens zwei LED-Chips (1), die unterschiedliche Werte der ersten photometrischen Größe aufweisen, derart, dass sich die Durchschnittswerte aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden , wobei die LED-Beleuchtungsvorrichtungen mindestens einen weiteren Durchschnittswert einer zweiten photometrischen Größe, der erste LED-Chip einen ersten Wert der zweiten photometrischen Größe und der zweite LED-Chip einen von dem ersten Wert unterschiedlichen zweiten Wert der zweiten photometrischen Größe aufweisen, wobei die LED-Chips derart zu Gruppen kombiniert werden, dass sich die Durchschnittswerte aller LED-Beleuchtungsvorrichtungen um weniger als 10 % voneinander unterscheiden und/oder sich die Durchschnittswerte um weniger als zehn MacAdam-Schwellwerteinheiten voneinander unterscheiden.

Die Gruppen von LED-Chips bilden hierbei jeweils einen Chipsatz für eine LED-Beleuchtungsvorrichtung. In einer nachfolgenden Herstellung einer LED-Beleuchtungsvorrichtung kann also jeweils eine Beleuchtungsvorrichtung mit zumindest einem solchen, insbesondere mit genau einem solchen, LED-Chipsatz bestückt werden. Die im Folgenden im Zusammenhang mit der LED-Beleuchtungsvorrichtung beschriebenen Merkmale sind daher auch für den LED-Chipsatz anwendbar.

Ein Durchschnittswert der ersten photometrischen Größe eines LED-Chipsatzes und somit einer LED-Beleuchtungsvorrichtung setzt sich insbesondere aus einer Überlagerung der Werte der ersten photometrischen Größe der einzelnen LED-Chips dieser LED-Beleuchtungsvorrichtung zusammen. Der Durchschnittswert der ersten photometrischen Größe einer LED-Beleuchtungsvorrichtung bezieht sich somit insbesondere lediglich auf jeweils eine LED-Beleuchtungsvorrichtung und nicht auf Werte der ersten photometrischen Größe mehrerer LED-Beleuchtungsvorrichtungen zueinander. Hinsichtlich des Durchschnittswerts wird somit jeweils eine LED-Beleuchtungsvorrichtung separat betrachtet.

Die erste photometrische Größe der LED-Chips und/oder der LED-Beleuchtungsvorrichtungen bezieht sich vorzugsweise auf auf die Helligkeitsempfindlichkeitskurve des Auges bezogene Eigenschaften, wie beispielsweise Farbwiedergabeindex, Lichtstrom, Farbtemperatur, Farbort, Lichtstärke, Leuchtdichte oder Abstrahlcharakteristik.

Die "Farbtemperatur" ist insbesondere ein Maß für den Farbeindruck einer Lichtquelle. Sie wird definiert als die Temperatur, auf die man einen Schwarzen Körper (Planck'schen Strahler) aufheizen müsste, damit er Licht einer Farbe abgibt, das bei gleicher Helligkeit und unter festgelegten Beobachtungsbedingungen der zu beschreibenden Farbe am ähnlichsten ist.

Unter dem "Farbort" werden insbesondere die Zahlenwerte verstanden, die die Farbe des emittierten Lichts der LED-Chips oder der LED-Beleuchtungsvorrichtung im CIE-Farbraum beschreiben.

Der "CIE-Farbraum" ist insbesondere das CIE-Normvalenzsystem (auch bekannt unter CIE 1931). Dem CIE-Normvalenzsystem werden Messwerte zugrunde gelegt, die auf einem Normalbeobachter bezogen sind, die in einer CIE-Normfarbtafel darstellbar sind. Die Fläche möglicher Farben ist bei der CIE-Normfarbtafel auf einem Koordinatensystem aufgetragen, auf dem der X- Anteil und Y-Anteil einer beliebigen Farbe direkt abgelesen werden können.

Bei einer bevorzugten Ausgestaltung bezieht sich die erste photometrische Größe der LED-Chips und/oder der LED-Beleuchtungsvorrichtungen auf eine extensive Größe, wie beispielsweise auf den Lichtstrom und/oder die Lichtstärke.

In diesem Fall können Unterschiede der Durchschnittswerte der ersten photometrischen Größe aller LED-Beleuchtungsvorrichtungen nicht mit dem menschlichen Auge wahrnehmbar sein, wenn sich diese Durchschnittswerte um weniger als 10 % voneinander unterscheiden.

Bei einer weiteren bevorzugten Ausgestaltung bezieht sich die erste photometrische Größe der LED-Chips und/oder der LED-Beleuchtungsvorrichtungen auf den Farbort und/oder die Farbtemperatur. In diesem Fall können Unterschiede der Durchschnittswerte der ersten photometrischen Größe aller LED-Beleuchtungsvorrichtungen nicht mit dem menschlichen Auge wahrnehmbar sein, wenn sich diese Durchschnittswerte um weniger als zehn, bevorzugt um weniger als fünf, besonders bevorzugt um weniger als drei MacAdam-Schwellwerteinheiten voneinander unterscheiden.

Das erfindungsgemäße Verfahren bemisst eine erste photometrische Größe der LED-Chips, die zur Bestückung einer LED-Beleuchtungsvorrichtung vorgesehen sind. In einem weiteren Verfahrensschritt werden die LED-Chips anhand der ermittelten Werte der ersten photometrischen Größe gezielt derart kombiniert, dass sich der Durchschnittswert der ersten photometrischen Größe unterschiedlicher LED-Beleuchtungsvorrichtungen um weniger als 10 % und/oder um weniger als zehn, bevorzugt um weniger als fünf, besonders bevorzugt um weniger als drei MacAdam-Schwellwerteinheiten voneinander unterscheidet.

Die erste photometrische Größe der LED--Beleuchtungsvorrichtungen liegt mit Vorteil in einem vorgegebenen, insbesondere engen Bereich. LED-Beleuchtungsvorrichtungen, die ein einheitliches Erscheinungsbild des Farbeindruckes aufweisen, werden mit Vorteil ermöglicht. Mit dem menschlichen Auge sichtbare Unterschiede des Farbeindrucks zwischen den LED-Beleuchtungsvorrichtungen können mit Vorteil vermieden werden.

Durch die Kombination von LED-Chips, die unterschiedliche Werte der ersten photometrischen Größe aufweisen, können mit Vorteil LED-Chips für LED-Beleuchtungsvorrichtungen Verwendung finden, die mit dem menschlichen Auge sichtbare Differenzen der ersten photometrischen Größe aufweisen, ohne dabei mit dem menschlichen Auge sichtbare Differenzen der Durchschnittswerte der photometrischen Größe der LED-Beleuchtungsvorrichtungen zu bewirken. LED-Chips, deren Werte der ersten photometrischen Größe sich über einen großen Bereich erstrecken, können so mit Vorteil Verwendung finden, wodurch sich mit Vorteil ein Verwurf von herkömmlicherweise sogenannten "unbrauchbaren" LED-Chips reduziert. Durch einen reduzierten Verwurf der LED-Chips ergibt sich ein Kostenvorteil in der Herstellung der LED-Beleuchtungsvorrichtungen.

Bei einem Verfahren zur Festlegung der ersten photometrischen Größe eines LED-Chips wird der CIE-Farbraum mit einem Gitternetz versehen. Dieses Netz umfasst zwei Scharen sich kreuzender Netzlinien, wobei die eine Schar durch eine Schar Judd'scher Geraden und die andere Schar durch die Linien für die Farborte eines Planck'schen Strahlers sowie die dazugehörigen Linien konstanter Schwellwertabweichung gegeben ist, sodass das Netz eine Mehrzahl von von Netzlinien begrenzten Netzzellen aufweist. Die Netzzellen sind insbesondere unter "Bins" bekannt. Jeder Netzzelle wird dabei eine Gruppe von Werten einer ersten photometrischen Größe zugeordnet.

Anschließend wird die erste photometrische Größe der LED-Chips bestimmt und jeweils diejenige Netzzelle festgestellt, in der jeweils die erste photometrische Größe des LED-Chips liegt.

Judd'sche Geraden im CIE-Farbraum sind als Geraden ähnlicher Farbtemperatur definiert. Sie können näherungsweise als Linien konstanter Farbtemperatur angesehen werden. Die Linie für die Farborte eines Planck'sehen Strahlers ist durch die Farborte eines Planck'schen Strahlers für verschiedene Temperaturen des Planck'schen Strahlers gegeben. Der Abstand eines Farborts zu dieser Linie wird in Schwellwerteinheiten (SWE), auch bekannt unter Standard Deviation of Color Matching (SDCM), bestimmt.

Das Herstellungsverfahren bemisst die erste photometrische Größe eines LED-Chips auf der Basis des menschlichen Auges in enger Anlehnung an den Planck'sehen Strahler und die Judd'schen Geraden, also Geraden ähnlichster Farbtemperatur. Die LED-Chips werden so in Gruppen sortiert, die dem farblichen Wahrnehmungsempfinden des menschlichen Auges entsprechen.

Bei einer bevorzugten Ausgestaltung ist der Unterschied der Werte der ersten photometrischen Größe der LED-Chips einer LED-Beleuchtungsvorrichtung mit dem menschlichen Auge wahrnehmbar.

LED-Chips, die unterschiedliche Werte der ersten photometrischen Größe aufweisen, die mit dem menschlichen Auge wahrnehmbar sind, können mit Vorteil derart kombiniert werden, dass Unterschiede des Farbeindrucks von einer Mehrzahl von LED-Beleuchtungsvorrichtungen nicht mit dem menschlichen Auge wahrnehmbar sind, insbesondere weniger als 10 % und/oder weniger als zehn, bevorzugt weniger als fünf, besonders bevorzugt weniger als drei MacAdam-Schwellwerteinheiten betragen. Durch die gezielte Kombination der LED-Chips mit unterschiedlichen Werten der ersten photometrischen Größe, deren Unterschied mit dem menschlichen Auge wahrnehmbar ist, ist mit Vorteil der Verwurf von so genannten unbrauchbaren LED-Chips reduziert und kann insbesondere vermieden werden. Dadurch ergibt sich im Herstellungsprozess vorzugsweise ein Kostenvorteil.

Bei einer bevorzugten Ausgestaltung ist die erste photometrische Größe der Farbort. Vorzugsweise ist der Unterschied der Werte der Farborte der LED-Chips einer LED-Beleuchtungsvorrichtung größer als drei Schwellwerteinheiten, insbesondere MacAdam-Schwellwerteinheiten. Beispielsweise ist der Unterschied größer als fünf MacAdam-Schwellwerteinheiten, besonders bevorzugt größer als zehn MacAdam-Schwellwerteinheiten.

Eine MacAdam-Schwellwerteinheit, auch bekannt unter MacAdam-Ellipse, ist jener Umfang im CIE-XYZ-Farbraum um einen Bezugsfarbort herum, in dem das menschliche Auge keine Abweichung von dem Bezugsfarbort wahrnehmen kann.

Ein Unterschied des Farborts der LED-Chips im Bereich von einer MacAdam-Schwellwerteinheit ist mit dem durchschnittlichen menschlichen Auge nicht wahrnehmbar. Ein Unterschied der ersten photometrischen Größe in einem Bereich von zwei bis drei MacAdam-Schwellwerteinheiten ist mit dem durchschnittlichen menschlichen Auge nur schwer wahrnehmbar. Unterschiede größer als vier MacAdam-Schwellwerteinheiten sind mit dem durchschnittlichen menschlichen Auge deutlich wahrnehmbar.

Der Unterschied der Werte der ersten photometrischen Größe der LED-Chips einer LED-Beleuchtungsvorrichtung, der bevorzugt größer als fünf MacAdam-Schwellwerteinheiten ist, ist somit mit dem menschlichen Auge wahrnehmbar.

Bei einer bevorzugten Ausgestaltung unterscheiden sich die Durchschnittswerte aller Beleuchtungsvorrichtungen um weniger als zehn MacAdam-Schwellwerteinheiten. Bevorzugt unterscheiden sich die Durchschnittswerte um weniger als fünf MacAdam-Schwellwerteinheiten, besonders bevorzugt um weniger als drei MacAdam-Schwellwerteinheiten.

Die Unterschiede im Farbeindruck der LED-Beleuchtungsvorrichtungen zueinander sind somit mit dem menschlichen Auge nicht wahrnehmbar. Nebeneinander montierte LED-Beleuchtungsvorrichtungen weisen so für das menschliche Auge einen ähnlichen, insbesondere einen gleichen Farbeindruck auf.

Bei einer bevorzugten Ausgestaltung ist die erste photometrische Größe die Helligkeit.

Bevorzugt unterscheiden sich die Durchschnittswerte aller LED-Beleuchtungsvorrichtungen um weniger als 10 %. Abweichungen der Durchschnittswerte der Helligkeit voneinander von weniger als 10 % sind mit dem menschlichen Auge kaum, nahezu nicht, wahrnehmbar. Besonders bevorzugt unterscheiden sich die Durchschnittswerte aller LED-Beleuchtungsvorrichtungen um weniger als 5 %.

Nebeneinander montierte LED-Beleuchtungsvorrichtungen weisen so bevorzugt kaum, insbesondere keine mit dem menschlichen Auge wahrnehmbaren Unterschiede in der Helligkeit auf.

Die LED-Beleuchtungsvorrichtungen weisen mindestens einen weiteren Durchschnittswert einer zweiten photometrischen Größe, der erste LED-Chip einen ersten Wert der zweiten photometrischen Größe und der zweite LED-Chip einen von dem ersten Wert unterschiedlichen zweiten Wert der zweiten photometrischen Größe auf, wobei die LED-Chips derart zu Gruppen kombiniert werden, dass Unterschiede der weiteren Durchschnittswerte aller LED-Beleuchtungsvorrichtungen nicht mit dem menschlichen Auge wahrnehmbar sind, sich insbesondere die weiteren Durchschnittswerte um weniger als 10 % und/oder um weniger als zehn, bevorzugt um weniger als fünf, besonders bevorzugt um weniger als drei MacAdam-Schwellwerteinheiten unterscheiden.

Somit werden jedem LED-Chip zwei photometrische Größen, vorzugsweise der Farbort und die Helligkeit, zugeordnet. Anschließend werden die LED-Chips vorzugsweise derart zu Gruppen kombiniert, dass die Durchschnittswerte aller LED-Beleuchtungsvorrichtungen der ersten photometrischen Größe und der zweiten photometrischen Größe um weniger als 10 % und/oder um weniger als zehn, bevorzugt um weniger als fünf, besonders bevorzugt um weniger als drei MacAdam-Schwellwerteinheiten voneinander abweichen. Insbesondere weichen die Durchschnittswerte des Farborts aller LED-Beleuchtungsvorrichtungen um weniger als zehn, bevorzugt um weniger als fünf, besonders bevorzugt um weniger als drei MacAdam-Schwellwerteinheiten und die Durchschnittswerte der Helligkeit aller LED-Beleuchtungsvorrichtungen um weniger als 10 % voneinander ab.

LED-Beleuchtungsvorrichtungen, die nahezu keine Abweichungen der Helligkeit und des Farborts aufweisen, können so mit Vorteil erzielt werden. Nebeneinander montierte LED-Beleuchtungsvorrichtungen weisen mit Vorteil keine Unterschiede der Helligkeit und des Farborts auf, die mit dem menschlichen Auge wahrnehmbar sind. LED-Beleuchtungsvorrichtungen mit einem reproduzierbaren Farbeindruck lassen sich so mit Vorteil erzeugen. Ein einheitliches Erscheinungsbild des Farbeindrucks aller LED-Beleuchtungsvorrichtungen ermöglicht sich so.

Bei einer bevorzugten Ausgestaltung wird jeweils einer LED-Beleuchtungsvorrichtung mindestens ein weiterer LED-Chip zugeordnet, der einen weiteren Wert der ersten photometrischen Größe und/oder der zweiten photometrischen Größe aufweist.

Jeweils eine LED-Beleuchtungsvorrichtung weist demnach mindestens drei LED-Chips auf, die derart zu einer Gruppe kombiniert werden, dass Unterschiede der Durchschnittswerte der ersten photometrischen Größe und/oder der zweiten photometrischen Größe aller LED-Beleuchtungsvorrichtungen mit dem menschlichen Auge nicht wahrnehmbar sind, sich insbesondere um weniger als 10 % und/oder um weniger als zehn, bevorzugt um weniger als fünf, besonders bevorzugt um weniger als drei MacAdam-Schwellwerteinheiten unterscheiden. Mit Vorteil können so drei oder mehr LED-Chips, die sich bezüglich der Werte der photometrischen Größen unterscheiden, kombiniert werden, ohne verworfen zu werden, wodurch sich in der Herstellung Kostenvorteile ergeben. Der Farbeindruck der LED-Beleuchtungsvorrichtungen wird dabei durch die gezielte Kombination der LED-Chips mit Vorteil nicht nachteilig beeinträchtigt.

Weiter ist erfindungsgemäß eine LED-Beleuchtungsvorrichtung vorgesehen, die Licht mit einem Durchschnittswert einer ersten photometrischen Größe emittiert. Die LED-Beleuchtungsvorrichtung weist einen ersten LED-Chip mit einem ersten Wert der ersten photometrischen Größe und einen zweiten LED-Chip mit einem von dem ersten Wert unterschiedlichen zweiten Wert der ersten photometrischen Größe auf. Der Unterschied des ersten und des zweiten Werts der ersten photometrischen Größe ist mit dem menschlichen Auge wahrnehmbar, so dass sich die Durchschnittswerte aller LED-Beleuchtungsvorrichtungen um weniger als 10 % voneinander unterscheiden und/oder sich die Durchschnittswerte um weniger als zehn MacAdam-Schwellwerteinheiten voneinander unterscheiden. Die LED-Chips emittieren gleichfarbiges Licht. Die LED-Chips emittieren Licht mit einem gleichen Farbgrundton.

LED-Chips, die mit dem menschlichen Auge wahrnehmbare unterschiedliche Farbeindrücke aufweisen, können mit Vorteil derart kombiniert werden, dass sich ein vorgegebener Durchschnittswert der ersten photometrischen Größe der LED-Beleuchtungsvorrichtung ergibt. Die LED-Chips emittieren dabei gleichfarbiges Licht.

"Gleichfarbig" bedeutet insbesondere eine vom menschlichen Betrachter, insbesondere Normalbetrachter, wahrgenommene gleiche Farbart. Die Grundfarbe wird dabei vom menschlichen Betrachter als gleich empfunden, beispielsweise als Weißlicht, wobei Abweichungen vom beispielsweise Weißpunkt im Farbraum als Farbstich auftreten können. Gleichfarbig ist demnach insbesondere ein gleicher Farbgrundton, beispielsweise weiß, wobei abweichende Farbstiche auftreten können, die mit dem menschlichen Auge wahrnehmbar sind.

Bevorzugt ist die erste photometrische Größe der Farbort. Besonders bevorzugt unterscheiden sich der erste Wert der ersten photometrischen Größe und der zweite Wert der ersten photometrischen Größe um mehr als drei, bevorzugt um mehr als fünf, besonders bevorzugt um mehr als zehn MacAdam-Schwellwerteinheiten.

Abweichungen des Farborts der LED-Chips zueinander sind demnach mit dem menschlichen Auge wahrnehmbar.

Bei einer bevorzugten Ausgestaltung ist die erste photometrische Größe die Helligkeit. Helligkeitsunterschiede der LED-Chips zueinander sind dabei mit dem menschlichen Auge wahrnehmbar.

Die LED-Beleuchtungsvorrichtungen weisen mindestens einen weiteren Durchschnittswert einer zweiten photometrischen Größe, der erste LED-Chip einen ersten Wert der zweiten photometrischen Größe und der zweite LED-Chip einen von dem ersten Wert unterschiedlichen zweiten Wert der zweiten photometrischen Größe auf, wobei der Unterschied des ersten und des zweiten Werts der zweiten photometrischen Größe mit dem menschlichen Auge wahrnehmbar ist, so dass sich die Durchschnittswerte aller LED-Beleuchtungsvorrichtungen um weniger als 10 % voneinander unterscheiden und/oder sich die Durchschnittswerte um weniger als zehn MacAdam-Schwellwerteinheiten voneinander unterscheiden.

Besonders bevorzugt ist die erste photometrische Größe der Farbort und die zweite photometrische Größe die Helligkeit.

LED-Chips der LED-Beleuchtungsvorrichtung unterscheiden sich demnach in ihrem Farbort und ihrer Helligkeit, wobei die Unterschiede mit bloßem menschlichen Auge wahrnehmbar sind.

Bei einer weiteren bevorzugten Ausgestaltung ist den LED-Chips in Abstrahlrichtung eine strahlungsdurchlässige Abdeckung nachgeordnet, die Streupartikel enthält.

Die Abdeckung ist mit Vorteil eine diffus streuende Abdeckung, die in der LED-Beleuchtungsvorrichtung bevorzugt als optisches Mischelement Verwendung findet. Die Abdeckung mischt bevorzugt das von den einzelnen LED-Chips einer LED-Beleuchtungsvorrichtung emittierte Licht derart, dass eine von der LED-Beleuchtungsvorrichtung emittierte Mischstrahlung erzeugt wird.

Bevorzugt sind die LED-Chips einer LED-Beleuchtungsvorrichtung auf einer gemeinsamen Platine, beispielsweise einer Trägerplatte angeordnet und elektrisch kontaktiert. Die Platine kann insbesondere eine Leiterplatte (PCB: printed circuit board) sein.

Besonders bevorzugt weist die LED-Beleuchtungsvorrichtung eine der Platine gegenüberliegende Strahlungsaustrittsseite auf, durch die in der LED-Beleuchtungsvorrichtung erzeugte Strahlung die LED-Beleuchtungsvorrichtung verlassen kann.

Bevorzugt sind die LED-Chips Dünnfilm-LED-Chips. Als Dünnfilm-LED-Chip wird im Rahmen der Anmeldung ein LED-Chip angesehen, während dessen Herstellung das Aufwachssubstrat, auf dem eine Halbleiterschichtenfolge, die jeweils einen LED-Chip umfasst, beispielsweise epitaktisch aufgewachsen wurde, abgelöst worden ist.

Die Schichten der LED-Chips basieren bevorzugt auf einem III/V-Verbindungshalbleitermaterial. Ein III/V-Verbindungshalbleitermaterial weist wenigstens ein Element aus der dritten Hauptgruppe, wie beispielsweise Al, Ga, In und ein Element aus der fünften Hauptgruppe, wie beispielsweise N, P, As auf. Insbesondere umfasst der Begriff III/V-Verbindungshalbleitermaterial die Gruppe der binären, ternären oder quaternären Verbindungen, die wenigstens ein Element aus der dritten Hauptgruppe und wenigstens ein Element aus der fünften Hauptgruppe enthalten, insbesondere Nitrid- und Phosphid-Verbindungshalbleiter. Eine solche binäre, ternäre oder quaternäre Verbindung kann zudem beispielsweise einen oder mehrere Dotierstoffe sowie zusätzliche Bestandteile aufweisen.

Bevorzugt weisen die LED-Chips jeweils eine aktive Schicht zur Strahlungserzeugung auf. Die aktive Schicht der LED-Chips weisen jeweils einen pn-Übergang, eine Doppelheterostruktur, einen Einfachquantentopf (SQW, single quantum well) oder eine Mehrfachquantentopfstruktur (MQW, multi quantum well) zur Strahlungserzeugung auf. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen.

Bevorzugt sind die LED-Chips, insbesondere die Platine, auf einem Kühlkörper angeordnet. So kann die im Betrieb der LED-Chips entstandene Wärme über den Kühlkörper optimal aus der LED-Beleuchtungsvorrichtung abgeführt werden.

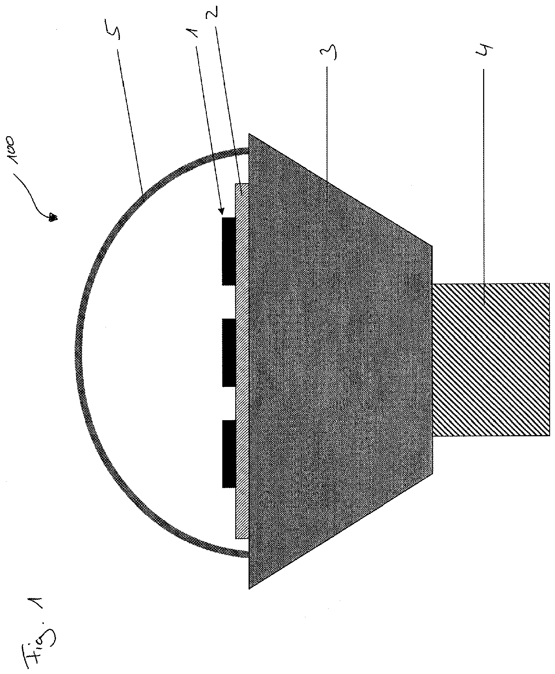

Weitere Merkmale, Vorteile, bevorzugte Ausgestaltungen und Zweckmäßigkeiten der LED-Beleuchtungsvorrichtung und das Verfahren zur Herstellung einer Mehrzahl von LED-Beleuchtungsvorrichtungen ergeben sich aus dem im Folgenden in Verbindung mit den Figuren 1 bis 7 erläuterten Ausführungsbeispielen.

Es zeigen:
- Figur 1: einen schematischen Querschnitt eines ersten Ausführungsbeispiels einer erfindungsgemäßen LED-Beleuchtungsvorrichtung,
- Figur 2: einen Ausschnitt aus dem CIE-Farbraum in der Umgebung der Linie des Planck'schen Strahlers,
- Figur 3: einen weiterer Ausschnitt aus dem CIE-Farbraum in der Umgebung der Linie des Planck'schen Strahlers mit darin dargestellten möglichen Kombinationen von Netzzellen jeweils einer Gruppe von zwei LED-Chips für eine weitere erfindungsgemäße LED-Beleuchtungsvorrichtung,
- Figur 4: einen weiterer Ausschnitt aus dem CIE-Farbraum in der Umgebung der Linie des Planck'schen Strahlers mit darin dargestellten weiteren Kombinationen von Netzzellen jeweils einer Gruppe von zwei LED-Chips für eine weitere erfindungsgemäße LED-Beleuchtungsvorrichtung,
- Figur 5: einen weiterer Ausschnitt aus dem CIE-Farbraum in der Umgebung der Linie des Planck'schen Strahlers mit darin dargestellten weiteren Kombinationen von Netzzellen jeweils einer Gruppe von drei oder vier LED-Chips für eine weitere LED-Beleuchtungsvorrichtung,
- Figur 6: einen schematisch dargestellten Ausschnitt der Helligkeitsempfindlichkeit zur Kombination zweier LED-Chips zu einer Gruppe einer weiteren erfindungsgemäßen LED-Beleuchtungsvorrichtung, und
- Figur 7: eine schematische Darstellung von möglichen Kombinationen von LED-Chips zu jeweils einer Gruppe jeweils einer weiteren LED-Beleuchtungsvorrichtung mit einer beliebigen photometrischen Größe Y.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

In Figur 1 ist ein Querschnitt eines Ausführungsbeispiels einer LED-Beleuchtungsvorrichtung 100 dargestellt. Die LED-Beleuchtungsvorrichtung 100 umfasst eine Lampenfassung 4, einen darauf angeordneten Kühlkörper 3, eine darauf angeordnete Platine 2 mit einer Mehrzahl von auf der Platine 2 angeordneten LED-Chips 1 und eine Abdeckung 5.

Die LED-Chips 1 weisen vorzugsweise jeweils eine zur Erzeugung von elektromagnetischer Strahlung geeignete aktive Schicht auf. Die LED-Chips 1 sind jeweils bevorzugt in Dünnfilmbauweise ausgeführt. Insbesondere umfassen die LED-Chips 1 bevorzugt epitaktisch abgeschiedene Schichten, die jeweils den LED-Chip 1 bilden. Die Schichten der LED-Chips 1 basieren bevorzugt auf einem III/V-Verbindungshalbleitermaterial.

Die Platine 2 der LED-Beleuchtungsvorrichtung 100 enthält bevorzugt ein thermisch leitfähiges Material. Besonders bevorzugt ist die Platine 2 eine Leiterplatte, insbesondere ein PCB.

Der Kühlkörper 3 enthält vorzugsweise ein thermisch leitfähiges Material. Bevorzugt wird die im Betrieb der LED-Chips 1 entstandene Wärme über die Platine 2 an den Kühlkörper 3 abgeleitet und von dort aus der LED-Beleuchtungsvorrichtung 100 an die Umgebung der LED-Beleuchtungsvorrichtung 100 abgegeben.

Die Abdeckung 5 ist den LED-Chips 1 bevorzugt in Abstrahlrichtung nachgeordnet. Die LED-Beleuchtungsvorrichtung 100 weist demnach eine der Platine 2 abgewandte Strahlungsaustrittsseite auf, aus der die von den LED-Chips 1 emittierte Strahlung austreten kann.
Bevorzugt ist die Abdeckung 5 für die von den LED-Chips 1 emittierte Strahlung strahlungsdurchlässig. Besonders bevorzugt enthält die Abdeckung 5 Streupartikel, bevorzugt diffus streuende Partikel. Die Abdeckung 5 dient somit als optisches Mischelement der von den einzelnen LED-Chips 1 emittierten Strahlung. Eine erhöhte Mischung der von den einzelnen LED-Chips 1 emittierten Strahlung erfolgt so mit Vorteil. Vorzugsweise emittiert die LED-Beleuchtungsvorrichtung 100 Mischstrahlung der von den LED-Chips 1 emittierten Strahlung.

Die LED-Chips 1 emittieren bevorzugt Strahlung im weißen Farbortbereich. Ein weißer Farbeindruck kann beispielsweise mittels Superposition einer ersten Wellenlänge und einer zweiten Wellenlänge entstehen. Vorzugsweise emittieren alle LED-Chips 1 der LED-Beleuchtungsvorrichtung 100 weißes Licht. Ein LED-Chip 1 der LED-Beleuchtungsvorrichtung 100 kann einen Halbleiterkörper, der eine erste Wellenlänge emittiert und zusätzlich einen Konverter, der die erste Wellenlänge zumindest teilweise in eine von der ersten Wellenlänge verschiedene zweite Wellenlänge konvertiert, aufweisen. Durch Überlagerung der ersten und der zweiten Wellenlänge kann der Eindruck weißen Lichts entstehen. Beispielsweise liegen die erste Wellenlänge im blauen Wellenlängenbereich und die zweite Wellenlänge im gelben Wellenlängenbereich.

Um Abweichungen der LED-Beleuchtungsvorrichtungen 100 zueinander zu minimieren, werden die LED-Chips 1 zu Gruppen von jeweils mindestens zwei LED-Chips 1 kombiniert. Die LED-Chips 1 weisen dabei unterschiedliche Werte einer ersten photometrischen Größe auf, wobei der Unterschied mit dem menschlichen Auge wahrnehmbar ist. Die Kombination der LED-Chips 1 zu Gruppen erfolgt derart, dass Unterschiede der Durchschnittswerte der ersten photometrischen Größe aller LED-Beleuchtungsvorrichtungen 100 zueinander nicht mit dem menschlichen Auge wahrnehmbar sind, sich insbesondere um weniger als 10 % und/oder um weniger als zehn, bevorzugt um weniger als fünf, besonders bevorzugt um weniger als drei MacAdam-Schwellwerteinheiten unterscheiden. Ein einheitliches Erscheinungsbild bezüglich des Farbeindrucks der LED-Beleuchtungsvorrichtungen 100 ermöglicht sich mit Vorteil.

Die gezielte Kombination von LED-Chips 1, die einen mit dem menschlichen Auge wahrnehmbaren Unterschied des jeweiligen Farbeindrucks aufweisen, ermöglicht einen Kostenvorteil in der Herstellung der LED-Beleuchtungsvorrichtung 100, da ein Verwurf von so genannten "unbrauchbaren" LED-Chips mit Vorteil reduziert wird.

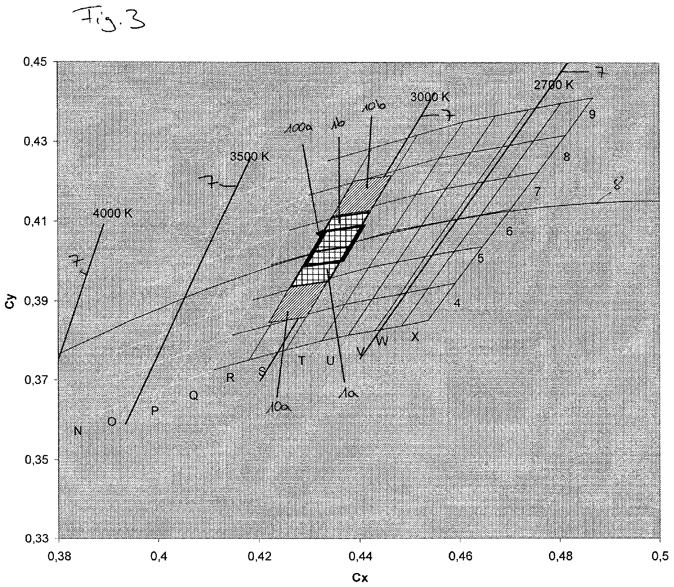

Das Verfahren zur Herstellung von LED-Beleuchtungsvorrichtungen 100 sowie die gezielte Kombination von LED-Chips 1 zu Gruppen ist in den Figuren 3 bis 7 jeweils näher erläutert.

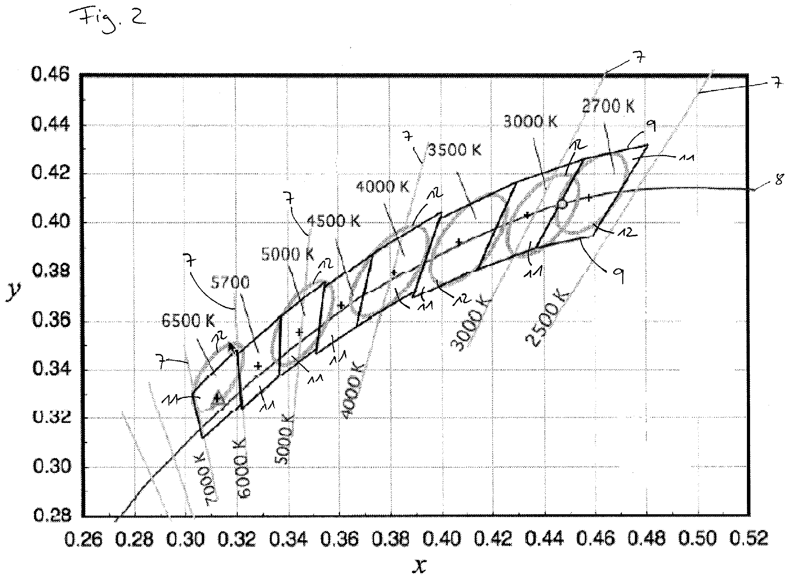

Figur 2 zeigt einen Ausschnitt aus dem CIE-Farbraum in der Umgebung der Linie des Planck'schen Strahlers.

Insbesondere ist in den Figuren 2 bis 5 der CIE-Farbraum 1931 dargestellt. Der dreidimensionale XYZ-Farbraum ist als zweidimensionale CIE-Normfarbtafel gezeigt.

Zur Festlegung eines Netzes sind Judd'sche Geraden 7 mit den Farbtemperaturen 2500 K, 3000 K, 4000 K, 5000 K, 6000 K und 7000 K eingetragen, die eine Schar von Gitternetzlinien bilden. Weiterhin ist die Linie 8 der Farborte eines Planck'schen Strahlers sowie Linien konstanter Schwellwertabweichungen 9 aufgetragen.

Ferner sind in Figur 2 Netzzellen 11 dargestellt, hier schwarz umrandete Kästchen, die als so genannte "Bins" bekannt sind.

LED-Chips, die jeweils in einer gemeinsamen Netzzelle 11 liegen, weisen jeweils ähnliche photometrische Größen auf.

Herkömmlicherweise werden LED-Chips, deren photometrische Größen in eine Netzzelle 11 fallen, jeweils zur Bestückung einer LED-Beleuchtungsvorrichtung verwendet. Allerdings unterscheiden sich nachteilig LED-Chips aus verschiedenen Bereichen, beispielsweise Ecken, einer Netzzelle 11 in ihrer photometrischen Größe, beispielsweise dem Farbort oder der Helligkeit, derart, dass dieser Unterschied mit dem menschlichen Auge wahrnehmbar ist.

In Figur 2 sind weiter MacAdam-Ellipsen 12 eingezeichnet. Eine MacAdam-Ellipse 12 ist jener Umfang im CIE-Diagramm um einen Bezugsfarbton herum, in dem das menschliche Auge keine Abweichung von dem Bezugsfarbort wahrnehmen kann. Photometrische Größen von LED-Chips, die innerhalb einer MacAdam-Ellipse fallen, werden von dem menschlichen Auge als gleich wahrgenommen.

Wie in Figur 2 dargestellt, weisen Netzzellen 11 jeweils Bereiche auf, die außerhalb einer MacAdam-Ellipse 12 liegen. Werte, die in solche Bereiche fallen, werden somit hinsichtlich eines Bezugsfarbtons vom menschlichen Auge als unterschiedlich aufgefasst. Diese Bereiche liegen insbesondere in Ecken einer jeweiligen Netzzelle 11. LED-Beleuchtungsvorrichtungen, die LED-Chips der gleichen Netzzelle 11 aufweisen, können so Abweichungen der photometrischen Durchschnittsgröße zueinander aufweisen, die mit dem menschlichen Auge wahrnehmbar sind, wodurch sich herkömmlicherweise ein uneinheitliches Erscheinungsbild der LED-Beleuchtungsvorrichtungen ergibt. Nebeneinander montierte LED-Beleuchtungsvorrichtungen, die jeweils LED-Chips einer Netzzelle 11 aufweisen, können so nachteilig mit dem Auge wahrnehmbare Unterschiede in beispielsweise dem Farbort oder der Helligkeit aufweisen.

Um diese Unterschiede zu vermeiden, werden daher LED-Chips mit unterschiedlichen Werten der photometrischen Größen derart kombiniert, dass Unterschiede der Durchschnittswerte verschiedener LED-Beleuchtungsvorrichtungen nicht mit dem menschlichen Auge wahrnehmbar sind, sich insbesondere um weniger als 10 % und/oder um weniger als zehn, bevorzugt um weniger als fünf, besonders bevorzugt um weniger als drei MacAdam-Schwellwerteinheiten voneinander unterscheiden, Erläuterungen, die Kombination der LED-Chips betreffend, sind in den Figuren 3 bis 5 gezeigt.

In den Figuren 3 bis 5 sind jeweils Ausschnitte aus dem CIE-Farbraum in der Umgebung der Linie des Planck'schen Strahlers 8 dargestellt. Wie in dem Ausführungsbeispiel der Figur 2 sind zur Festlegung des Netzes Judd'sche Geraden 7 eingetragen. Die Judd'schen Geraden der Figuren 3 bis 5 weisen die Farbtemperaturen 2700 K, 3000 K, 3500 K und 4000 K auf. Weiterhin sind, wie in Figur 2, Linien mit konstanten Schwellwertabweichungen aufgetragen.

Für die zu sortierenden LED-Chips wird erfindungsgemäß jeweils eine erste photometrische Größe, beispielsweise der Farbort oder die Helligkeit, eines jeden LED-Chips ermittelt und die zugehörige Netzzelle bestimmt. Anschließend werden LED-Chips zu Gruppen von jeweils mindestens zwei LED-Chips, die unterschiedliche Werte der ersten photometrischen Größe aufweisen, derart kombiniert, dass Unterschiede der Durchschnittswerte unterschiedlicher LED-Beleuchtungsvorrichtungen nicht mit dem menschlichen Auge wahrnehmbar sind, sich insbesondere die Durchschnittswerte aller LED-Beleuchtungsvorrichtungen um weniger als 10 % und/oder um weniger als zehn, bevorzugt um weniger als fünf, besonders bevorzugt um weniger als drei MacAdam-Schwellwerteinheiten unterscheiden.

Diese Gruppen von LED-Chips bilden jeweils Chipsätze, die zu LED-Beleuchtungsvorrichtungen weiterverarbeitet werden können.

Insbesondere werden in dem erfindungsgemäßen Herstellungsverfahren LED-Chips kombiniert, die in verschiedene Netzzellen fallen. Die Kombination der LED-Chips ergibt dann den Durchschnittswert der photometrischen Größe des Chipsatzes und somit der damit hergestellten der LED-Beleuchtungsvorrichtung. Durchschnittswerte verschiedener LED-Beleuchtungsvorrichtungen sind dabei so bestimmt, dass diese in einen vorgegebenen Netzzellenbereich fallen, in dem das menschliche Auge keine Abweichung von dem Bezugsfarbort wahrnehmen kann, also insbesondere ein Unterschied der photometrischen Größen der LED-Beleuchtungsvorrichtungen mit dem durchschnittlichen menschlichen Auge nicht wahrnehmbar ist. Die Durchschnittswerte aller LED-Beleuchtungsvorrichtungen liegen demnach in demselben Netzzellenbereich, während die Werte der LED-Chips in unterschiedliche Netzzellen fallen.
Ein erstes Ausführungsbeispiel von LED-Beleuchtungsvorrichtungen, die einen Durchschnittswert der ersten photometrischen Größe in einem gleichen Netzzellenbereich aufweisen, und damit mit dem menschlichen Auge wahrnehmbare Abweichungen der ersten photometrischen Größe der LED-Beleuchtungsvorrichtungen zueinander nahezu nicht aufweisen, ist in Figur 3 dargestellt.

Figur 3 gibt zwei LED-Beleuchtungsvorrichtungen an, die jeweils zwei LED-Chips aufweisen. Die LED-Vorrichtungen sind also jeweils mit einem Chipsatz mit zwei LED-Chips gebildet. Der Durchschnittswert jeweils einer LED-Beleuchtungsvorrichtung einer ersten photometrischen Größe, beispielsweise der Farbort oder die Helligkeit, liegt in dem Netzzellenbereich 100a, der in den Figuren 3 bis 5 jeweils als schwarz umrandeter Kasten dargestellt ist.

Die erste LED-Beleuchtungsvorrichtung weist einen ersten LED-Chip auf, dessen Wert der ersten photometrischen Größe in die Netzzelle 5S fällt, hier als schraffierter Bereich 10a dargestellt. Der zweite LED-Chip der ersten LED-Beleuchtungsvorrichtung weist einen Wert der ersten photometrischen Größe auf, der in die Netzzelle 8S fällt, hier als schraffierter Bereich 10b dargestellt. Durch Superposition der Werte der ersten photometrischen Größe des ersten LED-Chips und des zweiten LED-Chips der ersten LED-Beleuchtungsvorrichtung ergibt sich ein Durchschnittswert der ersten photometrischen Größe der LED-Beleuchtungsvorrichtung im Netzzellenbereich 100a.

Eine zweite LED-Beleuchtungsvorrichtung weist einen ersten LED-Chip auf, dessen Wert der ersten photometrischen Größe in die Netzzelle 6S fällt, hier als karierter Bereich 1a dargestellt. Ein zweiter LED-Chip der zweiten LED-Beleuchtungsvorrichtung weist einen zweiten Wert der ersten photometrischen Größe auf, der in den Bereich 7S fällt, hier als karierter Bereich 1b dargestellt. Durch Superposition der Werte der ersten photometrischen Größe des ersten LED-Chips und des zweiten LED-Chips der zweiten LED-Beleuchtungsvorrichtung ergibt sich ein Durchschnittswert, der in den Netzzellenbereich 100a fällt.

Demnach lassen sich durch eine gezielte Kombination von LED-Chips, die unterschiedliche Werte einer photometrischen Größe aufweisen, insbesondere in unterschiedliche Netzzellen fallen, LED-Beleuchtungsvorrichtungen herstellen, die hinsichtlich des Durchschnittswerts der photometrischen Größe in denselben Bereich 100a fallen. Abweichungen der Durchschnittswerte der photometrischen Größe zwischen den LED-Beleuchtungsvorrichtungen sind dabei nicht mit dem menschlichen Auge wahrnehmbar. Unterschiede der Werte der für eine LED-Beleuchtungsvorrichtung verwendeten LED-Chips dagegen können für das menschliche Auge wahrnehmbar sein, wobei durch eine gezielte Kombination der LED-Chips Abweichungen der Durchschnittswerte der ersten photometrischen Größe zwischen den LED-Beleuchtungsvorrichtungen nicht wahrnehmbar sind.

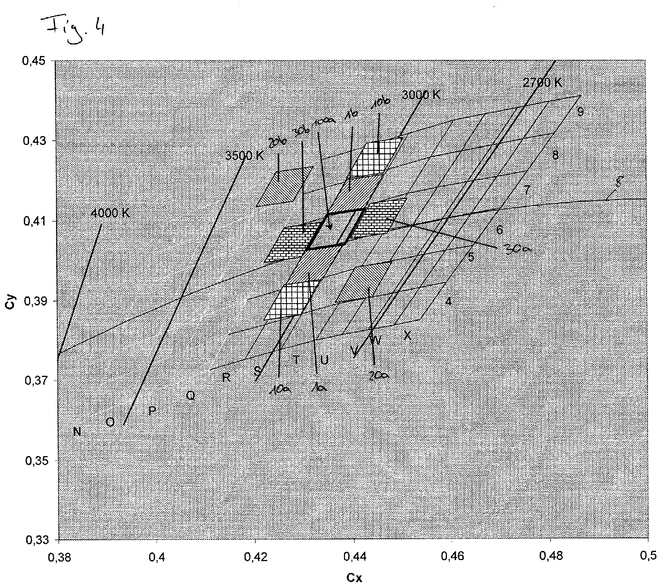

In Figur 4 sind, wie in dem Ausführungsbeispiel zu Figur 3, weitere gezielte Kombinationen von LED-Chips dargestellt, die jeweils einen Durchschnittswert einer LED-Beleuchtungsvorrichtung in demselben Netzzellenbereich 100a aufweisen.

Beispielsweise ergibt eine Kombination eines ersten LED-Chips, dessen Wert der ersten photometrischen Größe in die Netzzelle 5S fällt, hier dargestellt als karierter Bereich 10a, mit einem zweiten LED-Chip, dessen Wert der ersten photometrischen Größe in die Netzzelle 9S fällt, hier dargestellt als karierter Bereich 10b, einen Durchschnittswert der LED-Beleuchtungsvorrichtung, der in dem Netzzellenbereich 100a fällt.

Ebenso ergibt die Kombination eines ersten LED-Chips, dessen Wert der ersten photometrischen Größe in die Netzzelle 5U fällt, mit einer zweiten LED-Chip, dessen Wert der ersten photometrischen Größe in die Netzzelle 9Q fällt, hier jeweils als schraffierter Bereich 20a, 20b dargestellt, einen Durchschnittswert einer zweiten LED-Beleuchtung, der in dem Netzzellenbereich 100a fällt.

Ein solcher Durchschnittswert einer weiteren LED-Beleuchtungsvorrichtung mit zwei LED-Chips ergibt sich ferner aus einer Kombination eines ersten LED-Chips, dessen Wert der ersten photometrischen Größe in die Netzzelle 7R fällt, mit einem zweiten LED-Chip, dessen Wert in die Netzzelle 7T fällt, hier jeweils als Bereiche 30a, 30b dargestellt.

Ebenso ergibt sich dieser Durchschnittswert der photometrischen Größe, der in den Netzzellenbereich 100a fällt, durch eine Kombination eines LED-Chips, der einen Wert der ersten photometrischen Größe in der Netzzelle 6S aufweist, mit einem LED-Chip, der einen Wert der ersten photometrischen Größe in der Netzzelle 8S aufweist, hier als schraffierte Flächen 1a, 1b dargestellt.

LED-Beleuchtungsvorrichtungen, die jeweils zwei LED-Chips aufweisen und wie oben erläutert miteinander kombiniert werden, weisen jeweils einen Durchschnittswert der ersten photometrischen Größe auf, der in denselben Netzzellenbereich 100a fällt. Abweichungen der Durchschnittswerte zwischen den LED-Beleuchtungsvorrichtungen sind so mit dem menschlichen Auge nicht wahrnehmbar. Ein einheitliches Erscheinungsbild der LED-Beleuchtungsvorrichtungen ermöglicht sich mit Vorteil.

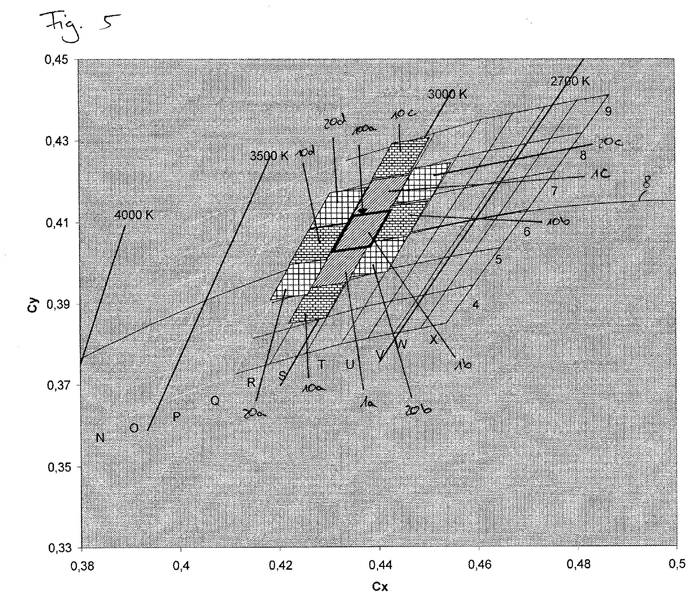

Figur 5 zeigt ein weiteres Ausführungsbeispiel einer weiteren möglichen gezielten Kombination von LED-Chips für LED-Beleuchtungsvorrichtungen, die reduzierte Differenzen von Durchschnittswerten einer ersten photometrischen Größe aufweisen.

Im Unterschied zu den in den Figuren 3 und 4 beschriebenen Ausführungsbeispielen werden in Figur 5 drei beziehungsweise vier LED-Chips zu Gruppen kombiniert, wobei die Durchschnittswerte der ersten photometrischen Größe der LED-Beleuchtungsvorrichtungen zueinander bevorzugt Abweichungen von weniger als 10 % und/oder um weniger als zehn, bevorzugt um weniger als fünf, besonders bevorzugt um weniger als drei MacAdam-Schwellwerteinheiten aufweisen.

Eine erste LED-Beleuchtungsvorrichtung weist drei LED-Chips auf, wobei der Wert der ersten photometrischen Größe eines ersten LED-Chips in die Netzzelle 6S fällt, der Wert der ersten photometrischen Größe eines zweiten LED-Chips in die Netzzelle 7S fällt, und der Wert der ersten photometrischen Größe eines dritten LED-Chips in die Netzzelle 6S fällt. Durch Superposition der Werte der ersten photometrischen Größe der drei LED-Chips ergibt sich ein Durchschnittswert, der in den Netzzellenbereich 100a fällt. Der Netzzellenbereich der Durchschnittswerte 100a ist als schwarz umrandeter Kasten, die Netzzelle der Werte des ersten, des zweiten und des dritten LED-Chips der ersten LED-Beleuchtungsvorrichtung ist jeweils als schraffierte Fläche 1a, 1b, 1c dargestellt.

Eine zweite Beleuchtungsvorrichtung weist vier LED-Chips auf, wobei der Wert der ersten photometrischen Größe eines ersten LED-Chips in die Netzzelle 6R fällt, der Wert der ersten photometrischen Größe eines zweiten LED-Chips in die Netzzelle 6T fällt, der Wert der ersten photometrischen Größe eines dritten LED-Chips in die Netzzelle 8T fällt und der Wert der ersten photometrischen Größe eines vierten LED-Chips in die Netzzelle 8R fällt, hier jeweils als karierte Fläche 20a, 20b, 20c, 20d dargestellt. Durch Superposition der Werte des ersten, des zweiten, des dritten und des vierten LED-Chips ergibt sich ein Durchschnittswert der ersten photometrischen Größe der zweiten LED-Beleuchtungsvorrichtung im Netzzellenbereich 100a.

Ebenso können vier LED-Chips kombiniert werden, deren Wert der ersten photometrischen Größe des ersten LED-Chips in die Netzzelle 5S, der Wert der ersten photometrischen Größe des zweiten LED-Chips in die Netzzelle 7T, der Wert der ersten photometrischen Größe des dritten LED-Chips in die Netzzelle 9S und der Wert der ersten photometrischen Größe des vierten LED-Chips in die Netzzelle 7R fällt, hier als Bereiche 10a, 10b, 10c, 10d dargestellt. Eine solche Kombination der LED-Chips ergibt ebenso wie bei der ersten und der zweiten LED-Beleuchtungsvorrichtung einen Durchschnittswert der ersten photometrischen Größe, der in den Netzzellenbereich 100a fällt.

Die erste LED-Beleuchtungsvorrichtung, die zweite LED-Beleuchtungsvorrichtung und die dritte LED-Beleuchtungsvorrichtung weisen so nahezu keine mit dem menschlichen Auge wahrnehmbaren Unterschiede der ersten photometrischen Größe auf.

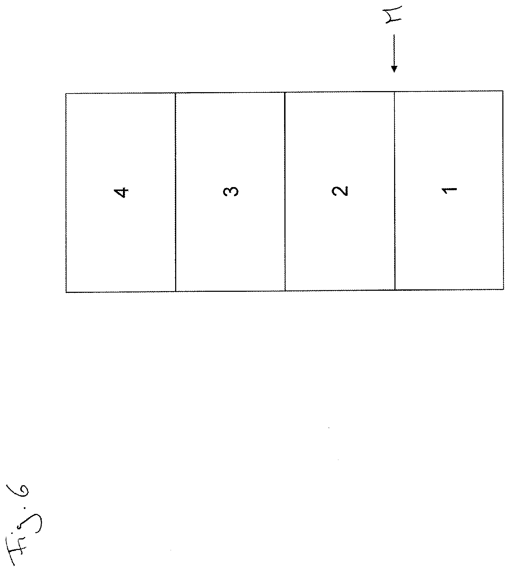

In dem Ausführungsbeispiel der Figur 6 ist ein Beispiel für die Kombination verschiedener Helligkeitsverteilungen von LED-Chips dargestellt. Die Helligkeit steigt von der Netzzelle 1 bis zu der Netzzelle 4 an. Insbesondere werden Helligkeiten, die in die Netzzelle 1 fallen, von dem menschlichen Auge als dunkel wahrgenommen, während Helligkeiten, die in die Netzzelle 4 fallen, von dem menschlichen Auge als hell wahrgenommen werden. Die vorgegebene Mindesthelligkeit M, die für LED-Chips in LED-Beleuchtungsvorrichtungen notwendig ist, ist in Figur 6 mittels eines Pfeils dargestellt.

Ist beispielsweise eine LED-Beleuchtungsvorrichtung erwünscht, die einen Durchschnittswert in der Netzzelle 2 aufweist, können LED-Chips kombiniert werden, die hinsichtlich ihrer Helligkeitsverteilung jeweils in die in Netzzelle 2 fallen. Alternativ können LED-Chips kombiniert werden, deren Helligkeitsverteilung in die Netzzelle 1 und die Netzzelle 3 fallen. Mittels Superposition ergibt sich dann eine LED-Beleuchtungsvorrichtung mit einer Helligkeitsverteilung, die in die Netzzelle 2 fällt.

Somit können mit Vorteil zusätzlich einige der zu dunklen LED-Chips aus der Netzzelle 1 genutzt werden und mit zu hellen LED-Chips aus der Netzzelle 3 kombiniert werden, um eine Beleuchtungsvorrichtung mit einer Helligkeitsverteilung in der Netzzelle 2 zu erzielen. Ein Ausschuss der LED-Chips minimiert sich so mit Vorteil. LED-Chips, deren Helligkeitsverteilung in Netzzellen 1 oder 3 fallen, zählen so mit Vorteil nicht zum Ausschuss des Herstellungsverfahrens und können weiter Verwendung finden.

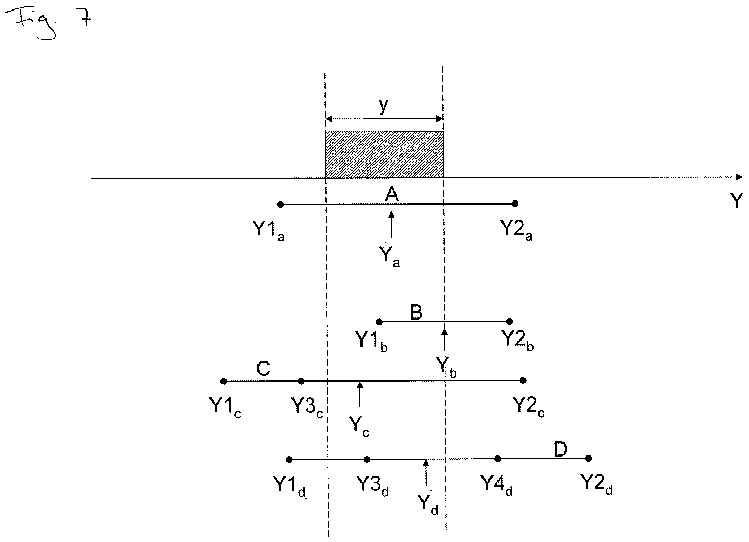

In Figur 7 sind mögliche Kombinationsbeispiele von LED-Chips, die jeweils eine beliebige photometrische Größe Y aufweisen, dargestellt. LED-Beleuchtungsvorrichtungen umfassend eine solche Kombination von LED-Chips weisen jeweils einen Durchschnittswert der photometrischen Größe Y auf.

Differenzen der Durchschnittswerte der photometrischen Größe Y der LED-Beleuchtungsvorrichtungen, die in den in Figur 7 gezeigten Bereich y fallen, sind mit dem menschlichen Auge nicht wahrnehmbar.

In Figur 7 sind die photometrischen Größen von LED-Beleuchtungsvorrichtungen A, B, C, D aufgeführt, die jeweils mindestens zwei LED-Chips aufweisen. Die Durchschnittswerte Yₐ, Y_{b}, Y_{c}, Y_{d} der vier LED-Beleuchtungsvorrichtungen A, B, C, D fallen jeweils in den gewünschten Bereich y, in dem Unterschiede der Werte mit dem menschlichen Auge nicht wahrnehmbar sind.

Die LED-Beleuchtungsvorrichtung A weist zwei LED-Chips 1ₐ, 2ₐ auf, deren Werte der photometrischen Größe Y1ₐ, Y2ₐ außerhalb des gewünschten Bereichs y liegen. Durch Kombination der LED-Chips 1ₐ, 2ₐ ergibt sich jedoch mit Vorteil ein Durchschnittswert Yₐ, der in den gewünschten Bereich fällt.

Ebenso ergibt sich ein gewünschter Durchschnittswert Y_{b} durch eine weitere mögliche Kombination zweier weiterer LED-Chips 1_{b}, 2_{b}.

Eine dritte LED-Beleuchtungsvorrichtung weist drei LED-Chips 1_{c}, 2_{c}, 3_{c} auf, deren Werte Y1_{c}, Y2_{c}, Y3_{c} der photometrischen Größe nicht in den Bereich y fallen, wobei jedoch der Durchschnittswert Y_{c} in dem Bereich y fällt.

Eine LED-Beleuchtungsvorrichtung D, die vier LED-Chips 1_{d}, 2_{d}, 3_{d}, 4_{d} aufweist, kann durch gezielte Kombination der LED-Chips ebenfalls einen Durchschnittswert Y_{d} der photometrischen Größe Y in dem gewünschten Bereich y aufweisen.

Wird mit LED-Chips, die nach einem derartigen Verfahren in Gruppen eingeteilt werden, eine LED-Beleuchtungsvorrichtung gebildet, wobei LED-Chips mit unterschiedlichen Werten einer photometrischen Größe verwendet werden, so weist diese LED-Beleuchtungsvorrichtung vorteilhaft geringe Farbabweichungen auf. Ein Verwurf von so genannten unbrauchbaren LED-Chips kann mit Vorteil reduziert, insbesondere vermieden werden, wodurch sich ein Kostenvorteil des Herstellungsverfahrens ergibt.

Die Erläuterung der erfindungsgemäßen LED-Beleuchtungsvorrichtung anhand der oben beschriebenen Ausführungsbeispiele ist nicht als Beschränkung der Erfindung auf diese zu betrachten. Die Erfindung wird durch die Ansprüche definiert.

## Patentansprüche

1. Verfahren zur Herstellung einer Mehrzahl von LED-Beleuchtungsvorrichtungen (100), die jeweils Licht mit einem Durchschnittswert (100a) einer ersten photometrischen Größe emittieren, mit den Verfahrensschritten:
- Herstellen einer Mehrzahl von LED-Chips (1), die Licht mit einem gleichen Farbgrundton emittieren,
- Messen der Werte der ersten photometrischen Größe der jeweiligen LED-Chips (1),
- Kombinieren der LED-Chips (1) zu Gruppen von jeweils mindestens zwei LED-Chips (1), die unterschiedliche Werte der ersten photometrischen Größe aufweisen, derart, dass sich die Durchschnittswerte (100a) aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden, und
- Bestücken jeweils einer LED-Beleuchtungsvorrichtung (100) mit einer Gruppe von LED-Chips (1), wobei
die LED-Beleuchtungsvorrichtungen (100) mindestens einen weiteren Durchschnittswert (100a) einer zweiten photometrischen Größe, der erste LED-Chip (1) einen ersten Wert der zweiten photometrischen Größe und der zweite LED-Chip (1) einen von dem ersten Wert unterschiedlichen zweiten Wert der zweiten photometrischen Größe aufweisen, wobei die LED-Chips (1) derart zu Gruppen kombiniert werden, dass sich die Durchschnittswerte (100a) aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden.

2. Verfahren zur Herstellung einer Mehrzahl von LED-Chipsätzen für Beleuchtungsvorrichtungen (100), die jeweils Licht mit einem Durchschnittswert (100a) einer ersten photometrischen Größe emittieren, mit den Verfahrensschritten:
- Herstellen einer Mehrzahl von LED-Chips (1), die Licht mit einem gleichen Farbgrundton emittieren,
- Messen der Werte der ersten photometrischen Größe der jeweiligen LED-Chips (1),
- Kombinieren der LED-Chips (1) zu Gruppen von jeweils mindestens zwei LED-Chips (1), die unterschiedliche Werte der ersten photometrischen Größe aufweisen, derart, dass sich die Durchschnittswerte (100a) aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden , wobei die LED-Beleuchtungsvorrichtungen (100) mindestens einen weiteren Durchschnittswert (100a) einer zweiten photometrischen Größe, der erste LED-Chip (1) einen ersten Wert der zweiten photometrischen Größe und der zweite LED-Chip (1) einen von dem ersten Wert unterschiedlichen zweiten Wert der zweiten photometrischen Größe aufweisen, wobei die LED-Chips (1) derart zu Gruppen kombiniert werden, dass sich die Durchschnittswerte (100a) aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden.

3. Verfahren gemäß Anspruch 1 oder 2,
wobei sich die Durchschnittswerte (100a) aller LED-Beleuchtungsvorrichtungen (100) um weniger als 10 % und/oder um weniger als fünf MacAdam-Schwellwerteinheiten unterscheiden.

4. Verfahren gemäß einem der vorhergehenden Ansprüche 1 bis 3, wobei der Unterschied der Werte der ersten photometrischen Größe der LED-Chips (1) einer LED-Beleuchtungsvorrichtung (100) mit dem menschlichen Auge wahrnehmbar ist.

5. Verfahren gemäß einem der vorhergehenden Ansprüche,
wobei die erste photometrische Größe der Farbort ist.

6. Verfahren gemäß Anspruch 5,
wobei der Unterschied der Werte der ersten photometrischen Größe der LED-Chips (1) einer LED-Beleuchtungsvorrichtung (100) größer als fünf MacAdam-Schwellwerteinheiten ist.

7. Verfahren gemäß Anspruch 6,
wobei sich die Durchschnittswerte aller LED-Beleuchtungsvorrichtungen (100) um weniger als drei MacAdam-Schwellwerteinheiten unterscheiden.

8. Verfahren gemäß einem der vorhergehenden Ansprüche 1 bis 4, wobei die erste photometrische Größe die Helligkeit ist.

9. Verfahren gemäß einem der vorhergehenden Ansprüche,
wobei jeweils einer LED-Beleuchtungsvorrichtung (100) mindestens ein weiterer LED-Chip (1) zugeordnet wird, der einen weiteren Wert der ersten photometrischen Größe und/oder der zweiten photometrischen Größe aufweist.

10. LED-Beleuchtungsvorrichtung (100),
- die Licht mit einem Durchschnittswert (100a) einer ersten photometrischen Größe und einem zweiten Durchschnittswert (100a) einer zweiten photometrischen Größe emittiert,
- einen ersten LED-Chip (1) mit einem ersten Wert der ersten photometrischen Größe und einen ersten Wert der zweiten photometrischen Größe aufweist, und
- einen zweiten LED-Chip (1) mit einem von dem ersten Wert unterschiedlichen zweiten Wert der ersten photometrischen Größe und mit einem von dem ersten Wert unterschiedlichen zweiten Wert der zweiten photometrischen Größe aufweist, wobei
- der Unterschied des ersten und des zweiten Werts der ersten photometrischen Größe mit dem menschlichen Auge wahrnehmbar ist, so dass sich die Durchschnittswerte aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden,
- der Unterschied des ersten und des zweiten Werts der zweiten photometrischen Größe mit dem menschlichen Auge wahrnehmbar ist, so dass sich die Durchschnittswerte aller LED-Beleuchtungsvorrichtungen (100) um weniger als 10 % voneinander unterscheiden und/oder sich die Durchschnittswerte um weniger als zehn MacAdam-Schwellwerteinheiten voneinander unterscheiden, und
- die LED-Chips (1) Licht mit einem gleichen Farbgrundton emittieren.

11. LED-Beleuchtungsvorrichtung gemäß Anspruch 10,
wobei die erste photometrische Größe der Farbort oder die Helligkeit ist.

12. LED-Beleuchtungsvorrichtung gemäß Anspruch 11,
wobei die erste photometrische Größe der Farbort ist und sich der erste Wert der ersten photometrischen Größe und der zweite Wert der ersten photometrischen Größe um mehr als fünf MacAdam-Schwellwerteinheiten unterscheiden.

13. LED-Beleuchtungsvorrichtung gemäß Anspruch 10,
wobei die photometrischen Größen der Farbort und die Helligkeit sind.

14. LED-Beleuchtungsvorrichtung gemäß einem der vorhergehenden Ansprüche 10 bis 13,
wobei den LED-Chips (1) in Abstrahlrichtung eine strahlungsdurchlässige Abdeckung (5) nachgeordnet ist, die Streupartikel enthält.

## Claims

1. A method for producing a plurality of LED illumination devices (100) which each emit light having an average value (100a) of a first photometric parameter, comprising the method steps:
- producing a plurality of LED chips (1) which emit light of the same basic color tone,
- measuring the values of the first photometric parameter of the respective LED chips (1),
- combining the LED chips (1) to groups of in each case at least two LED chips (1), which have different values of the first photometric parameter, in such a way that the average values (100a) of all the LED illumination devices (100) differ by less than 10% and/or by fewer than five MacAdam threshold units, and
- equipping a respective LED illumination device (100) with a group of LED chips (1), wherein the LED illumination devices (100) have at least one further average value (100a) of a second photometric parameter, the first LED chip (1) has a first value of the second photometric parameter and the second LED chip (1) has a second value of the second photometric parameter, said second value being different than the first value, wherein the LED chips (1) are combined to groups, in such a way that the average values (100a) of all the LED illumination devices (100) differ by less than 10% and/or by fewer than ten MacAdam threshold units.

2. Method for producing a plurality of LED chipsets for illumination devices (100) which each emit light having an average value (100a) of a first photometric parameter, comprising the method steps:
- producing a plurality of LED chips (1) which emit light of the same basic color tone,
- measuring the values of the first photometric parameter of the respective LED chips (1),
- combining the LED chips (1) to form groups of in each case at least two LED chips (1) which have different values of the first photometric parameter, in such a way that differences in the average values (100a) for the illumination devices (100) are imperceptible to the human eye,
- combining the LED chips (1) to groups of in each case at least two LED chips (1), which have different values of the first photometric parameter, in such a way that the average values (100a) of all the LED illumination devices (100) differ by less than 10% and/or by fewer than five MacAdam threshold units, wherein the LED illumination devices (100) have at least one further average value (100a) of a second photometric parameter, the first LED chip (1) has a first value of the second photometric parameter and the second LED chip (1) has a second value of the second photometric parameter, said second value being different than the first value, wherein the LED chips (1) are combined to groups, in such a way that the average values (100a) of all the LED illumination devices (100) differ by less than 10% and/or by fewer than ten MacAdam threshold units.

3. Method according to claim 1 or 2, wherein
the average values (100a) of all the LED illumination devices (100) differ by less than 10% and/or by fewer than five MacAdam threshold units.

4. Method according to one of the preceding claims 1 to 3, wherein
the difference in the values of the first photometric parameter of the LED chips (1) of an LED illumination device (100) is perceptible to the human eye.

5. Method according to one of the preceding claims, wherein the first photometric parameter is the color locus.

6. Method according to claim 5, wherein
the difference in the values of the first photometric parameter of the LED chips (1) of an LED illumination device (100) is greater than five MacAdam threshold units.

7. Method according to claim 6, wherein
the average values of all the LED illumination devices (100) differ by fewer than three MacAdam threshold units.

8. Method according to one of the preceding claims 1 through 4, wherein
the first photometric parameter is the brightness.

9. Method according to one of the preceding claims, wherein
a respective LED illumination device (100) is assigned at least one further LED chip (1) having a further value of the first photometric parameter and/or of the second photometric parameter.

10. LED illumination device (100),
- which emits light having an average value (100a) of a first photometric parameter and a second average value (100a) of a second photometric parameter,
- which has a first LED chip (1) having a first value of the first photometric parameter and having a first value of the second photometric parameter, and
- which has a second LED chip (1) having a second value of the first photometric parameter, said second value being different than the first value and having a second value of the second photometric parameter, said second value being different than the first value, wherein
- the difference between the first and second values of the first photometric parameter is perceptible to the human eye, such that the average values (100a) of all the LED illumination devices (100) differ by less than 10% and/or by fewer than ten MacAdam threshold units
- the difference between the first and second values of the second photometric parameter is perceptible to the human eye, such that the average values (100a) of all the LED illumination devices (100) differ by less than 10% and/or by fewer than ten MacAdam threshold units, and
- the LED chips (1) emit light of the same basic color tone.

11. LED illumination device according to claim 10, wherein the first photometric parameter is the color locus or brightness.

12. The LED illumination device according to claim 11, wherein the first photometric parameter is the color locus and the first value of the first photometric parameter and the second value of the first photometric parameter differ by more than five MacAdam threshold units.

13. LED illumination device according to claim 10, wherein the first photometric parameter is the color locus and brightness.

14. LED illumination device according to one of the preceding claims 10 to 13, wherein
a radiation-transmissive covering (5) containing scattering particles is disposed downstream of the LED chips (1) in the emission direction.

## Revendications

1. Procédé en vue de la fabrication d'une pluralité de dispositifs d'éclairage LED (100), qui émettent respectivement de la lumière avec une valeur moyenne (100a) d'une première grandeur photométrique, avec les étapes de procédé de :
- Fabrication d'une pluralité de puces électroniques à LED (1), qui émettent de la lumière avec une même nuance du fond coloré,
- Mesure des valeurs de la première grandeur photométrique des puces électroniques à LED (1) respectives,
- Combinaison des puces électroniques à LED (1) en des groupes respectifs d'au moins deux puces électroniques à LED (1), qui présentent des valeurs différentes de la première grandeur photométrique, de sorte que les valeurs moyennes (100a) de tous les dispositifs d'éclairage LED (100) se distinguent les unes des autres de moins de 10 % et/ou les valeurs moyennes se distinguent les unes des autres de moins de dix unités de valeur seuil MacAdam, et
- Équipement respectif d'un dispositif d'éclairage LED (100) par un groupe de puces électroniques à LED (1),
les dispositifs d'éclairage LED (100) présentant au moins une autre valeur moyenne (100a) d'une seconde grandeur photométrique, la première puce électronique à LED (1) présentant une première valeur de la seconde grandeur photométrique et la seconde puce électronique à LED (1) une seconde valeur différente de la première valeur de la seconde grandeur photométrique, les puces électroniques à LED (1) étant combinées en des groupes de sorte que les valeurs moyennes (100a) de tous les dispositifs d'éclairage LED (100) se distinguent les unes des autres de moins de 10 % et/ou les valeurs moyennes se distinguent les unes des autres de moins de dix unités de valeur seuil MacAdam.

2. Procédé en vue de la fabrication d'une pluralité de jeux de puces électroniques à LED pour des dispositifs d'éclairage LED (100), qui émettent respectivement de la lumière avec une valeur moyenne (100a) d'une première grandeur photométrique, avec les étapes de procédé de :
- Fabrication d'une pluralité de puces électroniques à LED (1), qui émettent de la lumière avec une même nuance du fond coloré,
- Mesure des valeurs de la première grandeur photométrique des puces électroniques à LED (1) respectives,
- Combinaison des puces électroniques à LED (1) en des groupes respectifs d'au moins deux puces électroniques à LED (1), qui présentent des valeurs différentes de la première grandeur photométrique, de sorte que les valeurs moyennes (100a) de tous les dispositifs d'éclairage LED (100) se distinguent les unes des autres de moins de 10 % et/ou les valeurs moyennes se distinguent les unes des autres de moins de dix unités de valeur seuil MacAdam, et les dispositifs d'éclairage LED (100) présentant au moins une autre valeur moyenne (100a) d'une seconde grandeur photométrique, la première puce électronique à LED (1) présentant une première valeur de la seconde grandeur photométrique et la seconde puce électronique à LED (1) une seconde valeur différente de la première valeur de la seconde grandeur photométrique, les puces électroniques à LED (1) étant combinées en des groupes de sorte que les valeurs moyennes (100a) de tous les dispositifs d'éclairage LED (100) se distinguent les unes des autres de moins de 10 % et/ou les valeurs moyennes se distinguent les unes des autres de moins de dix unités de valeur seuil MacAdam.

3. Procédé selon les revendications 1 ou 2,
les valeurs moyennes (100a) de tous les dispositifs d'éclairage à LED (100) se distinguant de moins de 10 % et/ou de moins de cinq unités de valeur seuil MacAdam.

4. Procédé selon une quelconque des revendications précédentes 1 à 3,
la différence des valeurs de la première grandeur photométrique des puces électroniques à LED (1) d'un dispositif d'éclairage à LED (100) étant perceptible avec l'oeil humain.

5. Procédé selon une quelconque des revendications précédentes, la première grandeur photométrique étant la localisation chromatique.

6. Procédé selon la revendication 5,
la différence des valeurs de la première grandeur photométrique des puces électroniques à LED (1) d'un dispositif d'éclairage à LED (100) étant supérieure à cinq unités de valeur seuil MacAdam.

7. Procédé selon la revendication 6,
les valeurs moyennes de tous les dispositifs d'éclairage à LED (100) se distinguant les unes des autres de moins de trois unités de valeur seuil MacAdam.

8. Procédé selon une quelconque des revendications précédentes 1 à 4,
la première grandeur photométrique étant la luminosité.

9. Procédé selon une quelconque des revendications précédentes, au moins une autre puce électronique à LED (1) qui présente une autre valeur de la première grandeur photométrique et/ou de la seconde grandeur photométrique étant affectée à respectivement un dispositif d'éclairage à LED (100).

10. Dispositif d'éclairage à LED (100),
- qui émet de la lumière avec une valeur moyenne (100a) d'une première grandeur photométrique et une seconde valeur moyenne (100a) d'une seconde grandeur photométrique,
- présente une première puce électronique à LED (1) avec une première valeur de la première grandeur photométrique et une première valeur de la seconde grandeur photométrique, et
- présente une seconde puce électronique à LED (1) avec une seconde valeur différente de la première valeur de la première grandeur photométrique et avec une seconde valeur différente de la première valeur de la seconde grandeur photométrique,
- la différence des première et seconde valeurs de la première grandeur photométrique étant perceptible avec l'oeil humain, de sorte que les valeurs moyennes de tous les dispositifs d'éclairage à LED (100) se distinguent les unes des autres de moins de 10 % et/ou les valeurs moyennes se distinguent les unes des autres de moins de dix unités de valeur seuil MacAdam,
- la différence des première et seconde valeurs de la seconde grandeur photométrique étant perceptible avec l'oeil humain, de sorte que les valeurs moyennes de tous les dispositifs d'éclairage à LED (100) se distinguent les unes des autres de moins de 10 % et/ou les valeurs moyennes se distinguent les unes des autres de moins de dix unités de valeur seuil MacAdam, et
- les puces électroniques à LED (1) émettant de la lumière avec une même nuance du fond coloré.

11. Dispositif d'éclairage LED selon la revendication 10,
la première grandeur photométrique étant la localisation chromatique ou la luminosité.

12. Dispositif d'éclairage LED selon la revendication 11,
la première grandeur photométrique étant la localisation chromatique, et la première valeur de la première grandeur photométrique et la seconde valeur de la première grandeur photométrique se distinguant de plus de cinq unités de valeur seuil MacAdam.

13. Dispositif d'éclairage LED selon la revendication 10,
les grandeurs photométriques étant la localisation chromatique et la luminosité.

14. Dispositif d'éclairage LED selon une quelconque des revendications précédentes 10 à 13,
un cache radiotransparent (5) étant disposé en aval des puces électroniques à LED (1) dans la direction de rayonnement, qui contient des particules de diffusion.
